# EUROPÄISCHE PATENTSCHRIFT

(11) **EP 3 443 825 B1**
(45) Veröffentlichungstag und Bekanntmachung des Hinweises auf die Patenterteilung: **06.05.2026**
(21) Anmeldenummer: 17711153.1
(22) Anmeldetag: 16.03.2017
(51) Int. Cl.: H05K 1/14, H05K 7/14, H05K 3/36

(54) **VERFAHREN ZUR POSITIONIERUNG VON LEITERPLATTEN UND LEITERPLATTENANORDNUNG**
METHOD FOR POSITIONING PRINTED CIRCUIT BOARDS, AND PRINTED CIRCUIT BOARD ARRANGEMENT
PROCÉDÉ DE POSITIONNEMENT DE CARTES DE CIRCUIT IMPRIMÉ ET ENSEMBLE DE CARTES DE CIRCUIT IMPRIMÉ

(30) Priorität: 14.04.2016 DE 102016106900
(43) Veröffentlichungstag der Anmeldung: 20.02.2019
(73) Patentinhaber: Endress+Hauser SE+Co. KG, 79689 Maulburg (DE)
(72) Erfinder: GIRARDEY, Romuald, 68730 Blotzheim (FR); BIRGEL, Dietmar, 79650 Schopfheim (DE); ZENUNI, Armend, 79539 Lörrach (DE); BARET, Marc, 68680 Kembs (FR); KLÖFER, Peter, 79585 Steinen (DE)
(74) Vertreter: Endress + Hauser Group Services (Deutschland) AG+Co. KG
(86) Internationale Anmeldenummer: PCT/EP2017/056208
(87) Internationale Veröffentlichungsnummer: WO 2017/178186

(56) Entgegenhaltungen:
- WO-A1-2016/019517
- DE-A1- 4 138 818
- DE-T2- 69 501 011
- US-A- 4 508 398

## Beschreibung

Die Erfindung betrifft ein Verfahren zur Positionierung von Leiterplatten in einem Gehäuse eines Feldgeräts der Prozess- und/oder Automatisierungstechnik, sowie eine Leiterplattenanordnung von miteinander elektrisch kontaktierten Leiterplatten in einem Gehäuse eines Feldgeräts der Prozess- und/oder Automatisierungstechnik.

In der Prozess- und Automatisierungstechnik werden Feldgeräte zur Bestimmung und/oder Überwachung von Prozessgrößen, insbesondere von physikalischen oder chemischen Prozessgrößen, eingesetzt. Ein Feldgerät umfasst typischerweise zumindest eine zumindest teilweise und zumindest zeitweise mit dem Prozess in Berührung kommende Sensoreinheit. Als Feldgeräte werden im Rahmen der vorliegenden Anmeldung im Prinzip alle Messgeräte bezeichnet, die prozessnah eingesetzt werden und die prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Solche Feldgeräte werden in unterschiedlichen Ausgestaltungen von der E+H Gruppe hergestellt und vertrieben.

Ein derartiges Feldgerät weist in der Regel elektronische Bauteile auf, welche üblicherweise auf einer ebenen Leiterplatte angeordnet und miteinander verlötet werden. Oftmals werden dabei mehrere Leiterplatten in einem nicht-leitenden Gehäuse des Feldgeräts oder einem leitenden Gehäuse mit einer zumindest nicht-leitenden Oberfläche eingebaut, wobei typischerweise die Ebenen der verschiedenen Leiterplatten im Gehäuse zueinander parallel ausgerichtet werden. Dabei sind eine oder mehrere elektrische Kontaktierungen zwischen den Leiterplatten vorgesehen, welche beispielsweise der Stromversorgung oder der Datenleitung zwischen den verschiedenen Leiterplatten dienen. Derartige Leiterplattenanordnungen in einem Gehäuse kommen in den verschiedensten Feldgeräten der E+H Gruppe zum Einsatz.

In der Regel müssen dabei zusätzliche Bauteile, welche der elektrischen Kontaktierung zwischen den im Gehäuse angeordneten und befestigten Leiterplatten dienen, in einem zusätzlichen Verfahrensschritt angebracht werden. Beispielsweise wird im Rahmen der Bestückung der Leiterplatten auf einer ersten Leiterplatte eine Buchse und auf einer zweiten, mit der ersten Leiterplatte zu kontaktierenden Leiterplatte ein zur Buchse passender Stecker aufgelötet. Die Buchse und der Stecker müssen dann in geeigneter Weise bei der Anordnung der beiden zu kontaktierenden Leiterplatte im Gehäuse in einem zusätzlichen Arbeitsschritt zusammengeführt werden.

Alternativ zu der Kontaktierung mit Buchse und Stecker sind aus dem Stand der Technik flexible, flache Verbindungselemente zur elektrischen Kontaktierung von Leiterplatten bekannt geworden; Beispiele für diese auch als Jumper bezeichneten flexiblen Verbindungselemente sind in der Patenschrift US 6 614 664 B2 oder der Offenlegungsschrift DE 10 2004 037 629 A1 gegeben. Diese flexiblen Verbindungselemente werden - beispielsweise im Rahmen der Bestückung - auf zwei in einer Ebene nebeneinander angeordneten Leiterplatten aufgelötet. Die flexiblen Verbindungselemente haben gegenüber der Verbindung mit Stecker und Buchse den Vorteil, dass die Verbindung von zwei Leiterplatten im Rahmen der Bestückung erfolgt und somit kein zusätzlicher Arbeitsschritt zur Verbindung notwendig ist. Die Formbarkeit der flexiblen Verbindungselemente ermöglicht es, durch Biegen oder Knicken der flexiblen Verbindungselemente die elektrische Kontaktierung zwischen den starren, ebenen Leiterplatten aus der Ebene der Leiterplatten heraus kontinuierlich in eine weitere Dimension zu führen. Werden die beiden nebeneinander angeordneten Leiterplatten aus der gemeinsamen Ebene heraus und in zwei zueinander parallele Ebenen gebracht, können die flexiblen Verbindungselemente dabei durch Biegen und/oder Knicken somit in eine zur Leiterplattenebene senkrechte Richtung geformt werden.

Prinzipiell ist es auch möglich, mehrere flexible Verbindungselemente zwischen zwei benachbarten Leiterplatten vorzusehen. Hierbei bestehen jedoch hohe Einschränkungen an die Anordnung der flexiblen Verbindungselemente, da sie dafür alle in einem gemeinsamen Randbereich (d.h. einer gemeinsamen Biegekante bzw. Knickkante) angeordnet werden müssten. Eine solche Anordnung der Verbindungselemente zwischen Leiterplatten ist nicht immer möglich, da durch die flexiblen Verbindungselemente in der Regel nicht mehr als zwei Leiterplatten ohne große Einschränkungen an die räumliche Positionierung der flexiblen Verbindungselemente in Bezug auf die Leiterplatten verbunden werden können. WO 2016/019517 A1 offenbart eine Leiterplattenanordnung in einem Gehäuse, bei dem die Gehäuserückwand eine Leiterplatte aufweist, in die weitere Leiterkarten eingesteckt werden können. Die Steckverbinder sind auf dieser rückwärtigen Leiterplatte miteinander verbunden, so dass auch die eingesteckten Leiteplatten miteinander verbunden sind.

Für den Einsatz von Feldgeräten in explosionsgefährdeten Bereichen sehen dagegen die Sicherheitsbeschränkungen zum Explosionsschutz eine räumliche Trennung von bestimmten Bereichen bzw. bestimmten elektrischen Kontaktierungen vor. Dabei geht es im Besonderen darum, die Bildung von Funken sicher zu vermeiden oder zumindest sicherzustellen, dass ein im Inneren eines abgeschlossenen Raumes allfällig entstehender Funke keine Auswirkungen auf die Umgebung hat, um so eine potentiell mögliche Auslösung einer Explosion sicher zu verhindern. Beispielsweise ist in der Europäischen Norm EN 60079-7:2007 ist eine Schutzklasse mit dem Namen "Erhöhte Sicherheit" (Ex-e) angegeben. Bei elektronischen Geräten, die gemäß dieser Schutzklasse ausgebildet sind, wird der Zünd- bzw. Explosionsschutz dadurch erzielt, dass die räumlichen Abstände zwischen zwei verschiedenen elektrischen Potentialen so groß sind, dass eine Funkenbildung auch im Fehlerfall aufgrund der Distanz nicht auftreten kann.

Für den Einsatz des Feldgeräts im explosionsgefährdeten Bereich ist es daher wünschenswert, ein automatisierbares und damit kostengünstiges Verfahren zur elektrischen Kontaktierung von Leiterplattenanordnungen in einem Gehäuse eines Feldgeräts zu erhalten, welches eine große Freiheit bezüglich der räumlichen Anordnungen der elektrischen Kontaktierungen ermöglicht.

Der Erfindung liegt daher die Aufgabe zugrunde, ein Verfahren zur gleichzeitigen Positionierung und elektrischen Kontaktierung der Leiterplatten in einem Gehäuse sowie ein Vorrichtung von in einem Gehäuse angeordneten Leiterplatten anzugeben, so dass nahezu keine Einschränkungen an die räumliche Anordnung der elektrischen Kontaktierungen herrschen.

Die Aufgabe wird bezüglich des Verfahrens nach Anspruch 1 gelöst durch ein Verfahren zur Positionierung mindestens zweier Leiterplatten in einem Gehäuse eines Feldgeräts der Automatisierungstechnik, wobei zumindest die Oberfläche des Gehäuses nicht-leitend ist, wobei im Gehäuse zumindest eine erste Befestigungsstelle zur Befestigung der ersten Leiterplatte und eine zweite Befestigungsstelle zur Befestigung der zweiten Leiterplatte an jeweils vorgegebenen Positionen vorgesehen sind, wobei zumindest eine im Gehäuse angeordnete Leiterbahn vorgesehen ist, wobei die Leiterbahn unlösbar mit dem Gehäuse verbunden ist, und wobei die Leiterbahn die erste Befestigungsstelle mit der zweiten Befestigungsstelle elektrisch kontaktiert, umfassend die Schritte:
- Vorfertigung der Leiterplatten sowie Vorfertigung des Gehäuses,
- Befestigung der Leiterplatten an den Befestigungsstellen des Gehäuses,
wobei bei der Befestigung der Leiterplatten die erste Leiterplatte mit der ersten Befestigungsstelle und die zweite Leiterplatte mit der zweiten Befestigungsstelle elektrisch kontaktiert wird, so dass die erste und die zweite Leiterplatte über die zumindest eine Leiterbahn miteinander elektrisch kontaktiert werden.

In dem erfindungsgemäßen Verfahren sind also die Leiterbahnen direkt in das Gehäuse integriert bzw. ein Bestandteil des Gehäuses. Dabei verlaufen die Leiterbahnen zwischen mindestens zwei Befestigungsstellen im Gehäuse. Durch die Befestigung der mindestens zwei Leiterplatten im Gehäuse wird ein elektrischer Kontakt zwischen den Leiterplatten und ihrer jeweiligen Befestigungsstelle hergestellt. Auf diese Art erfolgt erfindungsgemäß die elektrische Kontaktierung der mindestens zwei Leiterplatten gleichzeitig zu der Befestigung der Leiterplatten im Gehäuse. Dabei verlaufen die Leiterbahnen zwischen Befestigungsstellen, welche zur Befestigung der Leiterplatten an jeweils vorgegebenen Positionen vorgesehen sind. Auch die Leiterplatte wird dabei mit einem vorgegebenen Bereich an der vorgegebenen Position befestigt. Anhand der vorgegebenen Positionen und der Leiterbahnen, welche zwischen den Befestigungsstellen verlaufen, werden somit auch vorgegebene Bereiche der Leiterplatten miteinander elektrisch kontaktiert. Dies bedeutet, dass das Gehäuse und die darin verlaufenden Leiterbahnen so dimensioniert und ausgestaltet ist, dass sie zur Verbindung von vorgegebenen Bereichen von vorgegebenen Leiterplatten vorgesehen sind. Bei der Vorfertigung des Gehäuses im ersten Verfahrensschritt wird dabei das Gehäuse mitsamt den Befestigungsstellen und den zwischen den Befestigungsstellen verlaufenden Leiterbahnen mit der benötigten Topologie der Leiterbahnen, hergestellt.

In der Ausgestaltung des erfindungsgemäßen Verfahrens wird die im Gehäuse angeordnete und unlösbar mit dem Gehäuse verbundene Leiterbahn anhand eines Verfahren zur Herstellung von dreidimensionalen spritzgegossenen Schaltungsträgern bzw. Molded Interconnect Device (MID) erhalten. Bei einem MID handelt es sich um ein spritzgegossenes Kunststoffteil, in welches unlösbar eine metallische Struktur eingebracht wird, welche typischerweise als Leiterbahn ausgestaltet ist. Dabei herrschen nahezu keine Einschränkungen an die geometrische Form des Kunststoffteils und die räumliche Anordnung der metallischen Struktur innerhalb des Kunststoffteils. Eine Übersicht über die gängigen Herstellungsverfahren von MIDs wird beispielsweise von der "Forschungsvereinigung Räumliche Elektronische Baugruppen 3-D MID e.V." herausgegeben. Die gängigsten Verfahren zur Herstellung von MIDs umfassen dabei den Zweikomponentenspritzguss, Heißprägen, Maskenbelichtungsverfahren, Laserstrukturierung und Folienhinterspritzen. Dabei wird grundsätzlich zwischen subtraktiv strukturierenden und additiv metallisierenden Herstellungsverfahren unterschieden.

Bei der Laserdirektstrukturierung (LDS) erfolgt beispielsweise zunächst die vollflächige Metallisierung des Trägers. Danach wird die Metallschicht in einem subtraktiven Verfahren strukturiert. Die LDS ist in der Offenlegungsschrift DE 101 32 092 A1 und den darin zitierten Referenzen beschrieben. Demgegenüber ist das als "Flamecon" bezeichnete Herstellungsverfahren von MIDs ein additives Verfahren, in dem das aufzutragende Metall geschmolzen und durch Druck auf die Oberfläche aufgespritzt wird. Ein weiteres volladditives Herstellungsverfahren von MIDs ist das Heißprägeverfahren. Hierbei wird das Spritzgussteil in eine Prägepresse eingelegt, wobei eine oberflächenmodifizierte Metallfolie mit einem Prägewerkzeug gleichzeitig gestanzt und unter Verwendung von Druck und Wärme mit dem Spritzgussteil verbunden wird. Die hier genannten Herstellungsverfahren sind keineswegs vollständig; im Rahmen dieser Anmeldung werden daher MIDs als die Kombination aus einem spritzgegossenen Gehäuse und einer damit unlösbar verbundenen Leiterbahn bezeichnet, in der nahezu keine Einschränkung an die geometrische Form des Gehäuses sowie die Anordnung der Leiterbahn im Gehäuse besteht.

Der Einsatz von Verfahren zur Herstellung von MIDs bei der Herstellung eines derartigen Gehäuses würde prinzipiell sogar die Verwendung von Leiterplatten erübrigen, indem die elektronischen Bauteile direkt auf das Gehäuse bestückt werden. Allerdings müssten bei beliebig geformten Gehäusen dazu Bestückungsapparate verwendet werden, welche die vollständig dreidimensionale Bestückung von nicht-planaren Bauteilen ermöglichen. Ein derartiger Bestückungsapparat ist sehr kostenintensiv, so dass sich der vollkommene Verzicht von Leiterplatten nur für sehr spezielle und nicht automatisierbare Bestückungen eignet. Aus diesem Grund ist es bei der industriellen Herstellung eines Feldgeräts der Automatisierungstechnik in der Regel von Vorteil, die elektronischen Bauteilte eines Feldgeräts weiterhin auf ebenen Leiterplatten anzuordnen und die vollständig bestückten ebenen Leiterplatten miteinander elektrisch zu kontaktieren. Die dieser Ausgestaltung zugrunde liegende Idee ist also, die zur kostengünstigen Bestückung geeigneten, ebenen Leiterplatten beizubehalten, aber die Herstellungsverfahren der MIDs zur Herstellung des Gehäuses sowie der in das Gehäuse integrierten Leiterbahnen zu der elektrischen Kontaktierung der Leiterplatten zu verwenden. Ein derart hergestelltes vorgefertigtes Gehäuses mit integrierten Leiterbahnen eignet sich im besonders hohen Masse für das erfindungsgemäße Verfahren, in welchem die elektrischen Kontaktierung der Leiterplatten gleichzeitig zur Befestigung der Leiterplatten im Gehäuse erfolgt.

In einer weiteren Ausgestaltung wird das Gehäuse und/oder die im Gehäuse angeordnete und unlösbar mit dem Gehäuse verbundene Leiterbahn anhand eines generativen Fertigungsverfahren erhalten. Als generative Fertigungsverfahren bzw. 3D-Druck wird im Rahmen dieser Anmeldung diejenigen Verfahren bezeichnet, in denen ein Objekt durch stufenweises, computergesteuertes Aufbauen von Schichten mindestens eines Materials gebildet werden.

Bezüglich der Vorrichtung wird die Aufgabe mit Anspruch 3 gelöst durch eine Leiterplattenanordnung mit

mindestens zwei Leiterplatten, wobei die Leiterplatten in einem Gehäuse eines Feldgeräts der Automatisierungstechnik positioniert sind, wobei zumindest die Oberfläche des Gehäuses nicht-leitend ist, wobei das Gehäuse zumindest eine erste Befestigungsstelle zur Befestigung der ersten Leiterplatte und eine zweite Befestigungsstelle zur Befestigung der zweiten Leiterplatte an jeweils vorgegebenen Positionen aufweist, wobei die erste Leiterplatte mit der ersten Befestigungsstelle und die zweite Leiterplatte mit der zweiten Befestigungsstelle elektrisch kontaktiert sind, wobei zumindest eine im Gehäuse angeordnete Leiterbahn vorgesehen ist, wobei die Leiterbahn unlösbar mit dem Gehäuse verbunden ist, und wobei die Leiterbahn die erste Befestigungsstelle mit der zweiten Befestigungsstelle elektrisch kontaktiert, so dass anhand der im Gehäuse angeordneten Leiterbahn die erste und die zweite Leiterplatte miteinander elektrisch kontaktiert sind
Durch die im Gehäuse angeordneten bzw. im Gehäuse verlaufenden Leiterbahn zwischen den mindestens zwei Befestigungsstellen besteht nahezu keine Einschränkung an die räumliche Anordnung. Dabei können eine oder mehrere in das Gehäuse integrierte Leiterbahnen vorgesehen sein. Durch die Befestigung der mindestens zwei Leiterplatten im Gehäuse besteht ein elektrischer Kontakt zwischen der Leiterplatte und ihrer jeweiligen Befestigungsstelle. Das Gehäuse weist also Befestigungsstellen auf, welche gleichzeitig der Kontaktierung und der Befestigung der Leiterplatten mit der im Gehäuse angeordneten Leiterbahn dienen. Auf diese Art sind die Leiterplatten anhand der im Gehäuse angeordneten Leiterbahn und der Befestigungsstellen miteinander elektrisch kontaktiert. Selbstverständliche kann im Rahmen der Erfindung kann das Gehäuse auch weitere Befestigungsstellen im Gehäuse zur Befestigung der Leiterplatten aufweisen, wobei die weiteren Befestigungsstellen nur zur mechanischen Befestigung der Leiterplatten in dem Gehäuse ausgestaltet sind.

In einer Ausgestaltung der Leiterplattenanordnung sind die erste und die zweite Befestigungsstelle mehrfach elektrisch kontaktierbar, wobei das Gehäuse mindestens zwei voneinander elektrisch isolierte Leiterbahnen aufweist, und wobei anhand der voneinander elektrisch isolierten Leiterbahnen die erste und zweite Befestigungsstelle in voneinander elektrisch isolierten Bereichen miteinander mehrfach elektrisch kontaktiert sind. In dieser Ausgestaltung der Erfindung können natürlich auch mehr als zwei Leiterbahnen zur elektrischen Kontaktierung der beiden Befestigungsstellen vorgesehen sein.

In einer besonders bevorzugten Ausgestaltung der Leiterplattenanordnung
sind bei der elektrischen Kontaktierung die Leiterplatte und die Befestigungsstelle über eine Kontaktfläche kontaktiert, wobei anhand einer Dimensionierung der Befestigungsstelle sowie anhand der Ausgestaltung der Leiterplatte die Kontakteigenschaften der Kontaktfläche einstellbar sind.

Über die Ausgestaltung von Befestigungsstelle und der Leiterplatte lassen sich also die Kontakteigenschaften auf vorgebbare Werte einstellen.

Die Kontakteigenschaften sind im Rahmen dieser Anmeldung beispielsweise die Leitfähigkeit, die Stromtragfähigkeit, die mechanische und elektrische Belastbarkeit, der Übergangswiderstand, die Abmessungen der Kontaktfläche, u.s.w. Während bei einer handelsüblichen elektrischen Kontaktierungen (Stecker/Buche Paarung bzw. die flexiblen Verbindungselemente) die Kontakteigenschaften vorgegeben sind, ist es im Rahmen der Erfindung also möglich, die Kontakteigenschaften gezielt einzustellen.

Im Rahmen dieser Ausgestaltung ist es also möglich, an einer Leiterplatte mehrere Befestigungsstellen vorzusehen, wobei die Befestigungsstellen jeweils mit der Leiterplatte elektrisch kontaktiert ist, und wobei an der elektrischen Kontaktierung der jeweiligen Befestigungsstelle spezielle Kontakteigenschaften gewählt werden können. Damit ist es im Rahmen der Erfindung also möglich, dass dieselbe Art der Kontaktierung (nämlich über die Befestigungsstelle) je nach Befestigungsstelle unterschiedliche Kontakteigenschaften aufweist; dadurch erlaubt die Erfindung eine multifunktionale Kontaktierung. Diese Ausgestaltung der Erfindung eignet sich insbesondere dann, wenn das Feldgerät in explosionsgefährdeten Bereichen eingesetzt wird. Hier ist es aufgrund der wünschenswert, wenn über ausgezeichnete elektrische Kontaktierungen hohe Ströme fließen können, wohingegen an anderen elektrischen Kontaktierungen kleine Stromsignale gemessen werden müssen.

In einer Ausgestaltung der Erfindung ist zumindest eine der Befestigungsstellen als eine elastisch verformbare Nut ausgestaltet , wobei die Leiterplatte in die Nut einführbar ist, und wobei die Leiterplatte im Gehäuse anhand der Verbindung der Leiterplatte mit der elastisch verformbaren Nut befestigt ist.

Da die elastisch verformbare Nut bzw. die Befestigungsstelle Teil des Gehäuses ist, muss dazu in dieser Ausgestaltung das Gehäuse aus einem elastisch verformbaren Material sein. Durch das Einschieben der Leiterplatte in die elastisch verformbare Nut wird gewährleistet, dass ein von Null verschiedener Kontaktdruck in der elektrischen Kontakt der elektrischen Kontaktierung zwischen Befestigungsstelle und Leiterplatte herrscht. Dieser Kontaktdruck sorgt dafür, dass der elektrische Kontakt zwischen Befestigungsstelle und Leiterplatte langzeitstabil ist.

Diese Ausgestaltung kann auf besondere einfache Art und Weise mit der bevorzugten Ausgestaltung, in der anhand einer Dimensionierung der Befestigungsstelle sowie anhand der Ausgestaltung der Leiterplatte die Kontakteigenschaften der Kontaktfläche einstellbar sind, kombiniert werden.

Zum Beispiel lässt sich durch eine etwas dickere Leiterplatte der Kontaktdruck erhöhen und damit der Übergangswiderstand senken. Eine andere Möglichkeit ist, durch Modifikation der Leiterplattenoberfläche in dem zur Kontaktierung vorgesehenen Bereich die Leitfähigkeit zu beeinflussen, beispielsweise durch Hinzufügen von galvanischem Kontaktgold. Eine weitere Möglichkeit ist, die Dimensionierung der Kontaktfläche in Hinblick auf einen vorgebbaren Übergangswiderstand vorzunehmen, da der Übergangwiderstand im Wesentlichen invers proportional zur Kontaktfläche ist.

In einer weiteren Ausgestaltung der Erfindung ist eine elastisch verformbare Buchse auf der Leiterplatte angeordnet, wobei zumindest eine Befestigungsstelle als ein zur elastisch verformbaren Buchse passendes Gegenstück ausgestaltet ist, wobei das passende Gegenstück in die elastisch verformbare Buchse einführbar ist, und wobei die Leiterplatte im Gehäuse durch die Verbindung der elastisch verformbaren Buchse mit dem Gegenstück der elastisch verformbaren Buchse befestigt ist. Für den Fall, dass das Gehäuse selbst nicht elastisch verformbar ist, lässt sich in dieser Ausgestaltung der Erfindung der von Null verschiedene Kontaktdruck anhand der elastisch verformbaren Buchse erreichen. Auch hier liegt damit durch die elastisch verformbare Buchse ein von Null verschiedener Kontaktdruck in dem elektrischen Kontakt der elektrischen Kontaktierung zwischen Befestigungsstelle und Leiterplatte vor, so dass ein langzeitstabiler elektrischer Kontakt erhalten wird. Auch diese Ausgestaltung der Erfindung lässt sich mit der besonders bevorzugten Ausgestaltung kombinieren, in der die Kontakteigenschaften der Kontaktfläche einstellbar sind. Beispielsweise sind anhand der Dimensionierung der Befestigungsstelle die Kontakteigenschaften der Kontaktfläche einstellbar. Die Buchse kann dabei während der Bestückung der Leiterplatte zusammen mit den elektronischen Bauteilen aufgelötet werden.

In einer Weiterbildung der Erfindung ist eine isolierende Abdeckschicht vorgesehen, welche zumindest eine Leiterbahn zumindest abschnittweise abdeckt. Die isolierende Abdeckschicht wird dabei beispielsweise im Rahmen einer Vorfertigung des Gehäuses aufgebracht.

In einer weiteren Weiterbildung der Erfindung weist das Gehäuse mehrere Gehäusekomponenten auf. Dies bedeutet, dass sich das Gehäuse im Wesentlichen aus mehreren Komponenten zusammensetzt.

In einer bevorzugten Ausgestaltung dieser Weiterbildung ist eine erste Gehäusekomponente becherförmig, und eine weitere Gehäusekomponente deckelförmig. Die deckelförmige Gehäusekomponente ist dabei zum Verschließen der becherförmigen Gehäusekomponente ausgestaltet.

Zumindest eine Leiterbahn ist in der deckelförmigen Gehäusekomponente angeordnet. In dieser bevorzugten Ausgestaltung lassen sich also, beispielsweise durch Austausch der deckelförmigen Gehäusekomponente, verschiedene Arten der Kontaktierung der verschiedenen Leiterplatten realisieren.

In einer weiteren bevorzugten Ausgestaltung der Erfindung ist mindestens eine Gehäusekomponente dazu ausgestaltet, das Gehäuse in mindestens zwei voneinander räumlich abgetrennte Gehäusekammern aufzuteilen, wobei die erste Leiterplatte in der ersten Gehäusekammer und die zweite Leiterplatte in der zweiten Gehäusekammer angeordnet ist. Auch diese Ausgestaltung eignet sich insbesondere für den Einsatz in explosionsgefährdeten Bereichen. Dabei sind zumindest zwei Leiterplatten in zwei voneinander räumlich abgetrennten Bereichen angeordnet. Die voneinander räumlich abgetrennten Leiterplatten sind dabei über eine oder mehrere im Gehäuse und/oder in einer Gehäusekomponente angeordnete Leiterbahn miteinander elektrisch kontaktiert. Die in dieser bevorzugten Ausgestaltung erreichte räumliche Anordnung von Leiterplatten, Leiterbahnen und Gehäuse bzw. Gehäusekomponenten ist mit aus dem Stand der Technik bekannten Leiterplattenverbindungen ausgeschlossen. Insbesondere wird im Stand der Technik zur elektrischen Kontaktierung von räumlich getrennten Leiterplatten eine zusätzliche, durchführende Leiterplatte ("feed-through") verwendet. Im Rahmen der Erfindung kann dagegen diese im Stand der Technik benötigte, durchführende Leiterplatte eingespart und durch die im Gehäuse (bzw. in einer oder mehrerer Gehäusekomponente) angeordnete Leiterbahn (bzw. mehrere angeordnete Leiterbahnen) ersetzt werden.

In einer weiteren Ausgestaltung der Erfindung sind die erste und die zweite Leiterplatte im Wesentlichen in zueinander parallelen Ebenen angeordnet,
wobei die Leiterplatten anhand mindestens zweier Leiterbahnen miteinander elektrisch kontaktiert sind. Die beiden Leiterbahnen sind dabei im Wesentlichen an sich gegenüberliegenden Bereichen des Gehäuses angeordnet. Dadurch, dass zwei verschiedene Leiterbahnen zur mehrfachen elektrischen Kontaktierung von zwei Leiterplatten in sich gegenüberliegenden Bereichen des Gehäuses vorgesehen sind, eignet sich diese Ausgestaltung insbesondere auch für den Einsatz in explosionsgefährdeten Bereichen.

In einer Weiterbildung der Erfindung sind zumindest drei im Wesentlichen parallele Leiterplatten vorgesehen. Die drei parallelen Leiterplatten sind anhand zumindest zweier Leiterbahnen miteinander elektrisch kontaktiert,
wobei die beiden Leiterbahnen im Wesentlichen an sich gegenüberliegenden Bereichen des Gehäuses angeordnet sind. Auch dies ist vorteilhaft für den Einsatz in explosionsgefährdeten Bereichen.

In einer weiteren Ausgestaltung der Erfindung sind zumindest drei Leiterplatten vorgesehen, wobei anhand mindestens dreier voneinander isolierter Leiterbahnen jeweils die erste Leiterplatte mit der zweiten Leiterplatte (zum Beispiel anhand der ersten Leiterbahn), die zweite Leiterplatte mit der dritten Leiterplatte (zum Beispiel anhand der zweiten Leiterbahn) und die erste Leiterplatte mit der dritten Leiterplatte (zum Beispiel anhand der dritten Leiterbahn) elektrisch kontaktiert ist.

Die Erfindung wird anhand der nachfolgenden Figuren näher erläutert. Es zeigt:
Fig. 1a,b: Eine Seitenansicht auf Leiterplattenanordnungen gemäß dem Stand der Technik
Fig. 2a-c: Eine Seitenansicht auf erfindungsgemäße Leiterplattenanordnungen
Fig. 3a,b: Eine Seitenansicht auf weitere erfindungsgemäße Leiterplattenanordnungen
Fig. 4: Eine Aufsicht auf mehrfach kontaktierte Befestigungsstellen einer erfindungsgemäßen Leiterplattenanordnung

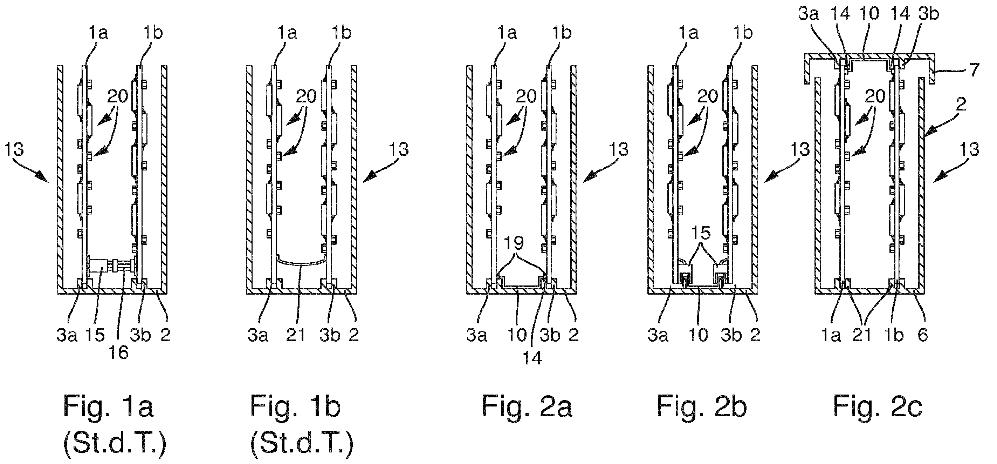

In Fig. 1 sind Verbindungen von Leiterplattenanordnungen 13 gemäß dem Stand der Technik dargestellt. Es ist eine Seitenansicht auf ein Gehäuse 2 eines Feldgeräts der Prozess- und Automatisierungstechnik und zwei darin angeordneten Leiterplatten 1a,1b gezeigt. Die Leiterplatten 1a,1b sind mit elektronischen Bauteilen 20 bestückt und in dem Gehäuse 2 an den Befestigungsstellen 3a,3b befestigt, welche im Stand der Technik nur der mechanischen Befestigung der Leiterplatten dienen. Die Verbindung der beiden Leiterplatten 1a,1b ist in Fig.1a mit Stecker 16 und Buchse 15 realisiert; damit erfolgt die Verbindung der beiden Leiterplatten 1a,1b in einem zusätzlichen Arbeitsschritt. In Fig. 1b ist die Verbindung der beiden Leiterplatten 1a,1b mit einem flexiblen Verbindungselement 21 realisiert. Das flexible Verbindungselement 21 weist gegenüber der Verbindung mit Stecker 16 und Buchse 15 zwar den Vorteil auf, das die Verbindung der beiden Leiterplatten 1a,1b im Rahmen der Bestückung mit den elektronischen Bauteilen 20 erfolgt. Allerdings herrschen dadurch große Einschränkung an die räumliche Anordnung der elektrischen Kontaktierung zwischen den Leiterplatten 1a,1b. Insbesondere die Verbindung von mehr als zwei Leiterplatten 1a,1b mit den flexiblen Verbindungselementen im Wesentlichen nicht praktikabel.

In Fig.2a-b sind erfindungsgemäße Leiterplattenanordnungen 13 gezeigt. Die Bezugszeichen sind dabei identisch zu denen aus Fig. 1. Der Einfachheit halber sind hier nur eine Leiterbahn 10 und zwei Leitplatten 1a,1b gezeigt, im Rahmen der Erfindung ist es aber selbstverständlich möglich, auch mehrere Leitbahnen 10, 11, 12 und Leiterplatten 1a, 1b, 1c vorzusehen. Im Unterschied zum Stand der Technik dienen die Befestigungsstellen 3a, 3b sowohl der mechanischen Befestigung der Leiterplatten 1a,1b im Gehäuse 2, als auch der elektrischen Kontaktierung der beiden Leiterplatten miteinander. Dafür ist eine unlösbar mit dem Gehäuse 2 verbundene Leiterbahn 10 vorgesehen, welche die Befestigungsstellen 3a,3b miteinander kontaktiert. Hierbei wird das Gehäuse 2 und die darin verlaufende Leiterbahn 10 vorgefertigt. Auch die vollständig bestückten Leiterplatten 1a,1b werden vorgefertigt. Dadurch wird ermöglicht, dass erfindungsgemäß die elektrische Kontaktierung der beiden Leiterplatten 1a,1b gleichzeitig zu dem Zusammenfügen des Gehäuses 2 und der Leiterplatten 1a,1b erfolgt, wobei die Leitplatten 1a,1b jeweils mit den Befestigungsstellen 3a,3b zwischen denen eine Leiterbahn 10 verläuft, elektrisch kontaktiert sind.

In Fig. 2a ist dabei die Variante der Erfindung gezeigt, in der die Befestigungsstelle 3a,3b als elastisch verformbare Nut 14 ausgestaltet ist. Die Leiterplatten 1a,1b können in dieser Ausgestaltung im Gehäuse 2 befestigt werden, indem die Leiterplatten 1a,1b in die elastisch verformbare Nut 14 eingeschoben werden. Dadurch wird die Befestigungsstelle 3a,3b mit der Leiterplatte 1a,1b bzw. einem Bereich der Leiterplatte 1a,1b elektrisch kontaktiert. In Fig. 2a ist zudem die Kontaktfläche 19 im elektrischen Kontakt zwischen Befestigungsstelle 3a,3b und Leiterplatte 1a, 1b dargestellt.

Für den Fall, dass das Gehäuse 2 aus einem nicht elastisch verformbaren Material ist, wird -beispielsweise im Rahmen der Bestückung bei der Vorfertigung der vollständig bestückten Leiterplatten 1a,1b- eine elastisch verformbare Buchse 15 auf den Leitplatten 1a,1b passend angeordnet. Diese Ausgestaltung ist in Fig. 2b gezeigt. In die elastische verformbare Buchse 15 kann dann das zur elastische verformbare Buchse 15 passende Gegenstück 16 eingeschoben werden. Dadurch wird die Befestigungsstelle 3a,3b mit der Leiterplatte 1a,1b bzw. einem Bereich der Leiterplatte 1a,1b elektrisch kontaktiert. Die Befestigungsstellen 3a,3b des Gehäuses 2 sind hier also als Gegenstück 16 ausgestaltet.

In Fig. 2c ist eine weitere Ausgestaltung der Leiterplattenanordnung 13 gezeigt. In dieser Ausgestaltung verläuft die die Befestigungsstellen 3a,3b elektrisch miteinander kontaktierende Leiterbahn 10 im Deckel 7 des Gehäuses bzw. in der deckelförmige Gehäusekomponente 7. Eine deckelförmige Gehäusekomponente 7 umfasst im Rahmen dieser Anmeldung dabei alle Gehäusekomponenten, welche zum Verschluss des Gehäuses 2 dienen, also z.B. auch eine das Gehäuse 2 verschließende Klappe, ein herausnehmbarer Boden, oder eine Endkappe. In dieser Ausgestaltung können ggf. weitere Befestigungsstellen 21,22 in der becherförmigen Gehäusekomponente 6 vorgesehen sein, wobei die weiteren Befestigungsstellen 21, 22 nur zur mechanischen Befestigung der Leiterplatten 1a,1b in dem Gehäuse 2 ausgestaltet sind.

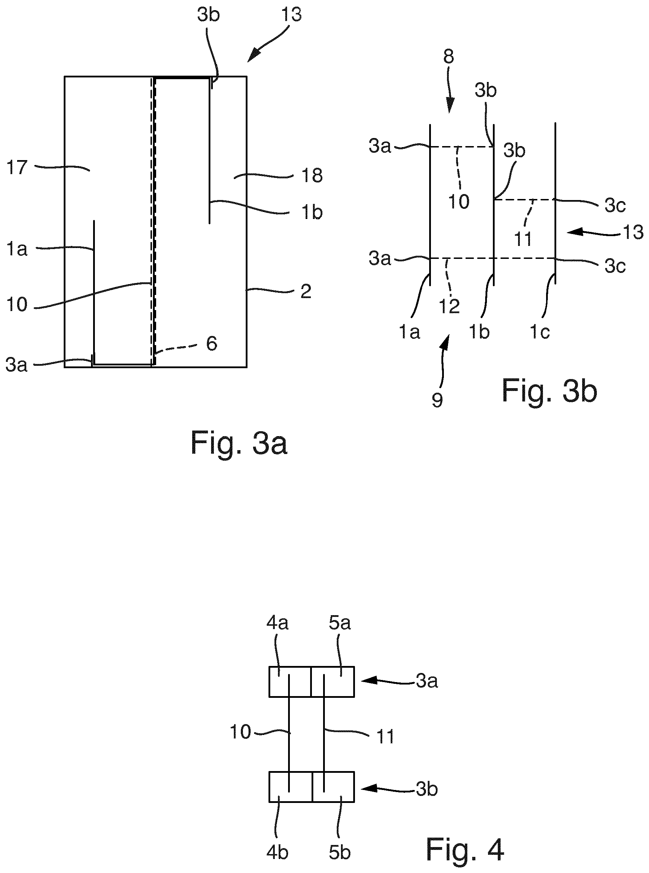

In Fig. 3a ist eine schematische Ansicht auf eine weitere erfindungsgemäße schematische Leiterplattenanordnung 13 gezeigt. In diesem Ausführungsbeispiel wird das Gehäuse 2 durch eine als Trennwand (gestrichelte Linie) ausgestaltete Gehäusekomponente 6 in zwei Gehäusekammern 17, 18 abgetrennt, wobei die Leiterplatten 1a, 1b in verschiedenen Gehäusekammern 17,18 angeordnet sein. Die unlösbar mit dem Gehäuse 2 verbundene Leiterbahn 10 verbindet die in den verschiedenen Gehäusekammern 17, 18 angeordneten Leiterplatten. Dabei ist die Leiterbahn 10 zumindest abschnittsweise durch eine Abdeckschicht abgedeckt.

In Fig. 3b ist eine schematische Seitenansicht auf ein Leiterplattenanordnung 13 von drei Leiterplatten 1a,1b,1c dargestellt; der Einfachheit halber wurde hier das Gehäuse 2 nicht dargestellt. Die Leiterplatten sind jeweils mit Befestigungsstellen des Gehäuses 3a,3b,3c elektrisch kontaktiert. Jede Leiterplatte 1a,1b,1c ist hierbei mit zwei verschiedenen Befestigungsstellen elektrisch kontaktiert. In dieser Anordnung ist anhand einer ersten Leiterbahn 10 die erste Leiterplatte 1a mit der zweiten Leiterplatte 1b, anhand einer zweiten Leiterbahn 11 die zweite Leiterplatte 1b mit der dritten Leiterplatte 1c und anhand einer dritten Leiterbahn 12 die erste Leiterplatte 1a mit der dritten Leiterplatte 1c elektrisch kontaktiert. Die Leiterbahnen 10,11,12 sind dabei als gestrichelte Linien dargestellt, und können an einer Seitenwand, dem Boden und/oder dem Deckel des Gehäuses 2 angeordnet sein. In diesem Ausführungsbeispiel ist die erste Leiterbahnen 10 in einem oberen, ersten Bereich 8 des Gehäuses 2 und die dritte Leiterbahn 12 in einem unteren, zweiten Bereich 9 des Gehäuses 2 angeordnet, welche sich im Wesentlichen gegenüberliegen. Dies gegenüberliegenden Bereiche 8,9 sind in diesem Beispiel der Boden und der Deckel, können aber auch sich gegenüberliegende Wände des Gehäuses 2 sein.

In Fig. 4 ist eine Aufsicht auf mehrfach kontaktierte Befestigungsstellen 3a,3b des Gehäuses 2 dargestellt; der Einfachheit halber wurde auch hier das Gehäuse 2 nicht dargestellt. Die Detailansicht zeigt die mehrfach kontaktierbaren Befestigungsstellen 3a, 3b und zwei Leiterbahnen 10,11 (stark verkürzt dargestellt). Dabei ist hier anhand der ersten Leiterbahn 10 ein erster Bereich 4a der ersten Befestigungsstelle 3a mit einem ersten Bereich 4b der zweiten Befestigungsstelle 3b elektrisch kontaktiert, sowie ein zweiter Bereich 5a der ersten Befestigungsstelle 3a mit einem zweiten Bereich 5b der zweiten Befestigungsstelle 3b anhand der zweiten Leiterbahn 11 elektrisch kontaktiert. Die Bereiche 4a und 5a sind gegeneinander elektrisch isoliert; auch die Bereiche 4b und 5b sind gegeneinander elektrisch isoliert.

### Bezugszeichenliste

- 1a: erste Leiterplatte
- 1b: zweite Leiterplatte
- 1c: dritte Leiterplatte
- 2: Gehäuse
- 3a: erste Befestigungsstelle
- 3b: zweite Befestigungsstelle
- 3c: dritte Befestigungsstelle
- 4a: erster Bereich der ersten Befestigungsstelle
- 5a: zweiter Bereich der ersten Befestigungsstelle
- 4b: erster Bereich der zweiten Befestigungsstelle
- 5b: zweiter Bereich der zweiten Befestigungsstelle
- 6: Gehäusekomponente
- 7: Gehäusekomponente
- 8: Bereich des Gehäuses
- 9: Bereich des Gehäuses
- 10: Leiterbahn
- 11: Leiterbahn
- 12: Leiterbahn
- 13: Leiterplattenanordnung
- 14: Nut
- 15: Buchse
- 16: Gegenstück zur Buchse
- 17: Gehäusekammer
- 18: Gehäusekammer
- 19: Kontaktfläche
- 20: elektronische Bauteile
- 21: weitere Befestigungsstellen
- 22: flexible Verbindungselemente

## Patentansprüche

1. Verfahren zur Positionierung mindestens zweier Leiterplatten (1a,1b) in einem Gehäuse (2) eines Feldgeräts der Automatisierungstechnik,
wobei zumindest die Oberfläche des Gehäuses nicht-leitend ist,
wobei das Gehäuse (2) zumindest eine erste Befestigungsstelle (3a) zur Befestigung der ersten Leiterplatte (1a) und eine zweite Befestigungsstelle (3b) zur Befestigung der zweiten Leiterplatte (1b) an jeweils vorgegebenen Positionen aufweist,
wobei zumindest eine im Gehäuse (2) angeordnete Leiterbahn (10) vorgesehen ist,
wobei die Leiterbahn (10) unlösbar mit dem Gehäuse (2) verbunden und in das Gehäuse (2) integriert ist,
und wobei die Leiterbahn (10) zwischen den Befestigungsstellen (3a,3b) verläuft und die erste Befestigungsstelle (3a) mit der zweiten Befestigungsstelle (3b) elektrisch kontaktiert, umfassend die Schritte:
- Vorfertigung der Leiterplatten (1a,1b) sowie Vorfertigung des Gehäuses (2), wobei die im Gehäuse (2) angeordnete und unlösbar mit dem Gehäuse (2) verbundene Leiterbahn (10) anhand eines Verfahrens zur Herstellung von dreidimensionalen Spritzgussschaltungsträgern, nämlich sogenannten Molded Interconnect Devices, erhalten wird,
- Befestigung der Leiterplatten (1a,1b) an den Befestigungsstellen (3a,3b) des Gehäuses (2),
wobei bei der Befestigung der Leiterplatten (1a,1b) die erste Leiterplatte (1a) mit der ersten Befestigungsstelle (3a) und die zweite Leiterplatte (1b) mit der zweiten Befestigungsstelle (3b) elektrisch kontaktiert wird,
so dass die erste (1a) und die zweite Leiterplatte (1b) über die zumindest eine Leiterbahn (10) miteinander elektrisch kontaktiert werden und dass die elektrische Kontaktierung der mindestens zwei Leiterplatten (1a,1b) gleichzeitig zu der Befestigung der Leiterplatten (1a,1b) in dem Gehäuse (2) erfolgt.

2. Verfahren nach Anspruch 1,
wobei das Gehäuse (2) anhand eines generativen Fertigungsverfahren erhalten wird.

3. Leiterplattenanordnung (13) mit mindestens zwei Leiterplatten (1a,1b),
wobei die Leiterplatten (1a,1b) in einem Gehäuse (2) eines Feldgeräts der Automatisierungstechnik positioniert sind,
wobei zumindest die Oberfläche des Gehäuses (2) nicht-leitend ist,
wobei das Gehäuse (2) zumindest eine erste Befestigungsstelle (3a) zur Befestigung der ersten Leiterplatte (1a) und eine zweite Befestigungsstelle (3b) zur Befestigung der zweiten Leiterplatte (1b) an jeweils vorgegebenen Positionen aufweist,
wobei die erste Leiterplatte (1a) mit der ersten Befestigungsstelle (3a) und die zweite Leiterplatte (1b) mit der zweiten Befestigungsstelle (3b) elektrisch kontaktiert sind,
wobei zumindest eine im Gehäuse (2) angeordnete Leiterbahn (10) vorgesehen ist,
wobei die Leiterbahn (10) unlösbar mit dem Gehäuse (2) verbunden und in das Gehäuse integriert ist,
wobei die im Gehäuse (2) angeordnete und unlösbar mit dem Gehäuse (2) verbundene Leiterbahn (10) anhand eines Verfahrens zur Herstellung von dreidimensionalen Spritzgussschaltungsträgern, nämlich sogenannten Molded Interconnect Devices, erhalten ist,
und wobei die Leiterbahn (10) zwischen den Befestigungsstellen (3a,3b) verläuft und die erste Befestigungsstelle (3a) mit der zweiten Befestigungsstelle (3b) elektrisch kontaktiert, so dass anhand der im Gehäuse (2) angeordneten Leiterbahn (10) die erste (1a) und die zweite Leiterplatte (1b) miteinander elektrisch kontaktiert sind und dass die elektrische Kontaktierung der mindestens zwei Leiterplatten (1a,1b) gleichzeitig zu der Befestigung der Leiterplatten (1a,1b) in dem Gehäuse (2) erfolgt.

4. Leiterplattenanordnung (13) nach Anspruch 3,
wobei die erste (3a) und zweite Befestigungsstelle (3b) mehrfach elektrisch kontaktierbar sind,
wobei das Gehäuse (2) mindestens zwei voneinander elektrisch isolierte Leiterbahnen (10,11) aufweist,
und wobei anhand der voneinander elektrisch isolierten Leiterbahnen (10,11) die erste (3a) und die zweite Befestigungsstelle (3b) jeweils in voneinander elektrisch isolierten Bereichen (4a,5a;4b,5b) miteinander mehrfach elektrisch kontaktiert sind.

5. Leiterplattenanordnung (13) nach zumindest einem der Ansprüche 3 bis 4,
wobei bei der elektrischen Kontaktierung die Leiterplatte (1a;1b) und die Befestigungsstelle (3a;3b) über eine Kontaktfläche (19) kontaktiert sind,
und wobei anhand einer Dimensionierung der Befestigungsstelle (3a;3b) sowie anhand der Ausgestaltung der Leiterplatte (1a;1b) die Kontakteigenschaften der Kontaktfläche (19) einstellbar sind.

6. Leiterplattenanordnung (13) nach zumindest einem der Ansprüche 3 bis 5,
wobei zumindest eine der Befestigungsstellen (3a;3b) als eine elastisch verformbare Nut (14) ausgestaltet ist,
wobei die Leiterplatte (1a;1b) in die Nut (14) einführbar ist,
und wobei die Leiterplatte (1a;1b) im Gehäuse (2) anhand der Verbindung der Leiterplatte (1a;1b) mit der elastisch verformbaren Nut befestigt ist.

7. Leiterplattenanordnung (13) nach zumindest einem der Ansprüche 3 bis 6,
wobei eine elastisch verformbare Buchse (15) auf der Leiterplatte (1a;1b) angeordnet ist,
wobei zumindest eine Befestigungsstelle(3a;3b) als ein zur elastisch verformbaren Buchse (15) passendes Gegenstück (16) ausgestaltet ist,
wobei das passende Gegenstück (16) in die elastisch verformbare Buchse (15) einführbar ist,
und wobei die Leiterplatte (1a;1b) im Gehäuse (2) durch die Verbindung der elastisch verformbaren Buchse (15) mit dem Gegenstück (16) der elastisch verformbaren Buchse (15) befestigt ist.

8. Leiterplattenanordnung (13) nach zumindest einem der Ansprüche 3 bis 7,
wobei eine isolierende Abdeckschicht zumindest eine Leiterbahn (4;4b) zumindest abschnittweise abdeckt.

9. Leiterplattenanordnung (13) nach zumindest einem der Ansprüche 3 bis 8,
wobei das Gehäuse (2) mehrere Gehäusekomponenten (6,7) aufweist.

10. Leiterplattenanordnung (13) nach Anspruch 9,
wobei eine erste Gehäusekomponente (6) becherförmig ist,
wobei eine weitere Gehäusekomponente (7) deckelförmig ist,
wobei die deckelförmige Gehäusekomponente (7) zum Verschließen der becherförmigen Gehäusekomponente (6) ausgestaltet ist,
und wobei die zumindest eine Leiterbahn (10) in der deckelförmigen Gehäusekomponente (7) angeordnet ist.

11. Leiterplattenanordnung (13) nach Anspruch 9 oder 10,
wobei mindestens eine Gehäusekomponente (6) dazu ausgestaltet ist,
das Gehäuse (2) in mindestens zwei voneinander räumlich abgetrennte Gehäusekammern (17,18) aufzuteilen,
und wobei die erste Leiterplatte (1a) in der ersten Gehäusekammer (17) und die zweite Leiterplatte (1b) in der zweiten Gehäusekammer (18) angeordnet ist.

12. Leiterplattenanordnung (13) nach zumindest einem der Ansprüche 3 bis 11,
wobei die erste (1a) und die zweite Leiterplatte (1b) im Wesentlichen in zueinander parallelen Ebenen angeordnet sind,
wobei die Leiterplatten (1a,1b) anhand mindestens zweier Leiterbahnen (10,11) miteinander elektrisch kontaktiert sind,
und wobei die beiden Leiterbahnen (10,11) im Wesentlichen an sich gegenüberliegenden Bereichen (8,9) des Gehäuses (2) angeordnet sind.

13. Leiterplattenanordnung (13) nach zumindest einem der Ansprüche 3 bis 12,
wobei zumindest drei im Wesentlichen parallele Leiterplatten (1a,1b,1c) vorgesehen sind,
wobei die drei parallelen Leiterplatten (1a,1b,1c) anhand zumindest zweier Leiterbahnen (10,11) miteinander elektrisch kontaktiert sind,
wobei die beiden Leiterbahnen (10,11) im Wesentlichen an sich gegenüberliegenden Bereichen (8,9) des Gehäuses (2) angeordnet sind.

14. Leiterplattenanordnung (13) nach zumindest einem der Ansprüche 3 bis 13,
wobei zumindest drei Leiterplatten (1a,1b,1c) vorgesehen sind,
und wobei anhand mindestens dreier voneinander isoliertet Leiterbahnen (10,11,12) jeweils
- die erste Leiterplatte (1a) mit der zweiten Leiterplatte (1b),
- die zweite Leiterplatte (1b) mit der dritten Leiterplatte (1c) und
- die erste Leiterplatte (1a) mit der dritten Leiterplatte (1c),
elektrisch kontaktiert ist.

## Claims

1. Method for positioning at least two printed circuit boards (1a, 1b) in a housing (2) of a field device for automation technology,
wherein at least the surface of the housing is non-conductive,
wherein the housing (2) has at least a first fastening point (3a) for fastening the first printed circuit board (1a) and a second fastening point (3b) for fastening the second printed circuit board (1b) at predetermined positions,
wherein at least one conductor track (10) arranged in the housing (2) is provided,
wherein the conductor track (10) is permanently connected to the housing (2) and intearated into the housing (2),
and wherein the conductor track (10) runs between the fastening points (3a, 3b) and electrically contacts the first fastening point (3a) with the second fastening point (3b), comprising the steps:
- Prefabrication of the printed circuit boards (1a, 1b) and prefabrication of the housing (2), wherein the conductor track (10) arranged in the housing (2) and permanently connected to the housing (2) is obtained by means of a process for manufacturing three-dimensional injection-molded circuit carriers, namely so-called molded interconnect devices,
- Fastening of the printed circuit boards (1a, 1b) to the fastening points (3a, 3b) of the housing (2),
wherein, when fastening the printed circuit boards (1a, 1b), the first printed circuit board (1a) is electrically contacted with the first fastening point (3a) and the second printed circuit board (1b) is electrically contacted with the second fastening point (3b),
so that the first (1a) and second (1b) printed circuit boards are electrically connected to each other via the at least one conductor track (10), and that the electrical contacting of the at least two printed circuit boards (1a, 1b) takes place simultaneously with the fastening of the printed circuit boards (1a, 1b) in the housing (2).

2. Method according to claim 1,
wherein the housing (2) is obtained by means of a generative manufacturing process.

3. Printed circuit board assembly (13) with at least two printed circuit boards (1a,
1b), wherein the printed circuit boards (1a, 1b) are arranged in a housing (2) of a field device of the automation technology,
wherein at least the surface of the housing (2) is non-conductive,
wherein the housing (2) has at least a first fastening point (3a) for fastening the first printed circuit board (1a) and a second fastening point (3b) for fastening the second printed circuit board (1b) at respective predetermined positions,
wherein the first printed circuit board (1a) is electrically connected to the first fastening point (3a) and the second printed circuit board (1b) is electrically connected to the second fastening point (3b), wherein at least one conductor track (10) arranged in the housing (2) is provided,
wherein the conductor track (10) is permanently connected to the housing (2) and is arranged in the housing
is integrated,
wherein the conductor track (10) arranged in the housing (2) and permanently connected to the housing (2) is obtained by means of a method for manufacturing three-dimensional injection-molded circuit carriers, namely so-called molded interconnect devices,
and wherein the conductor track (10) runs between the fastening points (3a, 3b) and the first fastening point (3a) is electrically connected to the second fastening point (3b), so that the first (1a) and second (1b) printed circuit boards are electrically connected to each other by means of the conductor track (10) arranged in the housing (2) and so that the electrical connection of the at least two printed circuit boards (1a, 1b) is simultaneous with the fastening
of the printed circuit boards (1a, 1b) in the housing (2).

4. Printed circuit board arrangement (13) according to claim 3,
wherein the first (3a) and second fastening points (3b) can be electrically connected multiple times,
wherein the housing (2) has at least two electrically insulated conductor tracks (10, 11),
and wherein, by means of the electrically insulated conductor tracks (10, 11), the first (3a) and second (3b) fastening points are each electrically connected to each other multiple times in electrically insulated areas (4a, 5a; 4b, 5b).

5. Printed circuit board arrangement (13) according to at least one of claims 3 to 4,
wherein, during electrical contacting, the printed circuit board (1a; 1b) and the fastening point (3a; 3b) are contacted via a contact surface (19),
and wherein, based on the dimensions of the fastening point (3a; 3b) and based on the design of the printed circuit board (1a; 1b), the contact properties of the contact surface (19) can be adjusted.

6. Circuit board arrangement (13) according to at least one of claims 3 to 5,
wherein at least one of the fastening points (3a; 3b) is designed as an elastically deformable groove (14),
wherein the printed circuit board (1a; 1b) can be inserted into the groove (14),
and wherein the printed circuit board (1a; 1b) is fastened in the housing (2) by means of the connection of the printed circuit board (1a; 1b) to the elastically deformable groove.

7. Circuit board arrangement (13) according to at least one of claims 3 to 6,
wherein an elastically deformable socket (15) is arranged on the printed circuit board (1a; 1b),
wherein at least one fastening point (3a; 3b) is designed as a counterpart (16) matching the elastically deformable socket (15),
wherein the matching counterpart (16) can be inserted into the elastically deformable bushing (15) ,
and wherein the printed circuit board (1a; 1b) is secured in the housing (2) by connecting the elastically deformable bushing (15) to the counterpart (16) of the elastically deformable bushing (15).

8. Printed circuit board assembly (13) according to at least one of claims 3 to 7, wherein an insulating cover layer covers at least one conductor track (4; 4b) at least in sections.

9. Printed circuit board arrangement (13) according to at least one of claims 3 to 8,
wherein the housing (2) has a plurality of housing components (6, 7).

10. Printed circuit board assembly (13) according to claim 9,
wherein a first housing component (6) is cup-shaped, wherein a further housing component (7) is lid-shaped,
wherein the lid-shaped housing component (7) is designed to close the cup-shaped housing component (6),
and wherein the at least one conductor track (10) is arranged in the cover-shaped housing component (7).

11. Printed circuit board arrangement (13) according to claim 9 or 10,
wherein at least one housing component (6) is designed to divide the housing (2)
into at least two housing chambers (17, 18) that are spatially separated from each other,
and wherein the first printed circuit board (1a) is arranged in the first housing chamber (17) and the second
printed circuit board (1b) is arranged in the second housing chamber (18).

12. Circuit board arrangement (13) according to at least one of claims 3 to 11, wherein the first (1a) and second (1b) circuit boards are arranged essentially in planes parallel to each other,
wherein the printed circuit boards (1a, 1b) are connected by means of at least two conductor tracks (10, 11) are electrically connected to each other,
and wherein the two conductor tracks (10, 11) are arranged essentially at opposite areas (8, 9) of the housing (2).

13. Printed circuit board arrangement (13) according to at least one of claims 3 to 12,
wherein at least three substantially parallel printed circuit boards (1a, 1b, 1c) are provided, wherein the three parallel printed circuit boards (1a, 1b, 1c) are electrically connected to each other by means of at least two conductor tracks (10, 11),
wherein the two conductor tracks (10, 11) are substantially opposite each other areas (8, 9) of the housing (2).

14. Circuit board arrangement (13) according to at least one of claims 3 to 13, wherein at least three circuit boards (1a, 1b, 1c) are provided,
and wherein, on the basis of at least three conductor tracks (10, 11, 12) isolated from one another each
- the first printed circuit board (1a) with the second printed circuit board (1b),
- the second printed circuit board (1b) is electrically contacted with the third printed circuit board (1c), and
- the first printed circuit board (1a) with the third printed circuit
board (1c) are electrically connected.

## Revendications

1. Procédé pour positionner au moins deux cartes de circuits imprimés (1a, 1b) dans un boîtier (2) d'un appareil de terrain de la technique d'automatisation,
la surface du boîtier étant au moins non conductrice,
le boîtier (2) comportant au moins un premier point de fixation (3a) pour la fixation de la première carte de circuit imprimé (1a) et un deuxième point de fixation (3b) pour la fixation de la deuxième carte de circuit imprimé (1b) à des positions prédéfinies,
au moins une piste conductrice (10) étant prévue dans le boîtier (2),
la piste conductrice (10) étant reliée de manière indétachable au boîtier (2) et intégrée dans le boîtier (2),
et la piste conductrice (10) s'étendant entre les points de fixation (3a, 3b) et reliant électriquement le premier point de fixation (3a) au deuxième point de fixation (3b), comprenant les étapes suivantes :
- Préfabrication des cartes de circuits imprimés (1a, 1b) ainsi que préfabrication du boîtier (2), la piste conductrice (10) disposée dans le boîtier (2) et reliée de manière indétachable au boîtier (2) est obtenue à l'aide d'un procédé de fabrication de supports de circuits imprimés moulés par injection en trois dimensions, appelés Molded Interconnect Devices,
- Fixation des circuits imprimés (1a, 1b) aux points de fixation (3a, 3b) du boîtier (2),
la première carte de circuit imprimé (1a) étant mise en contact électrique avec le premier point de fixation (3a) et la deuxième carte de circuit imprimé (1b) avec le deuxième point de fixation (3b) lors de la fixation des cartes de circuit imprimé (1a, 1b),
de sorte que la première (1a) et la deuxième (1b) cartes de circuits imprimés sont mises en contact électrique l'une avec l'autre par l'intermédiaire de la au moins une piste conductrice (10) et que la mise en contact électrique des au moins deux cartes de circuits imprimés (1a, 1b) s'effectue simultanément à la fixation des cartes de circuits imprimés (1a, 1b) dans le boîtier (2).

2. Procédé selon la revendication 1,
le boîtier (2) étant obtenu à l'aide d'un procédé de fabrication génératif.

3. Ensemble de cartes de circuits imprimés (13) comprenant au moins deux
cartes de circuits imprimés (1a, 1b), les cartes de circuits imprimés (1a, 1b) étant disposées dans un boîtier (2) d'un appareil de terrain de la
technique d'automatisation,
la surface du boîtier (2) étant au moins non conductrice,
le boîtier (2) comportant au moins un premier point de fixation (3a) pour la fixation de la première carte de circuit imprimé (1a) et un deuxième point de fixation (3b) pour la fixation de la deuxième carte de circuit imprimé (1b) à des positions prédéfinies respectives,
la première carte de circuit imprimé (1a) étant en contact électrique avec le premier point de fixation (3a) et la deuxième carte de circuit imprimé (1b) étant en contact électrique avec le deuxième point de fixation (3b), au moins une piste conductrice (10) étant prévue dans le boîtier (2),
la piste conductrice (10) étant reliée de manière indétachable au boîtier (2) et disposée dans le boîtier
est intégré,
la piste conductrice (10) disposée dans le boîtier (2) et reliée de manière indétachable au boîtier (2) étant obtenue à l'aide d'un procédé de fabrication de supports de circuits imprimés moulés par injection en trois dimensions, appelés Molded Interconnect Devices,
et la piste conductrice (10) s'étendant entre les points de fixation (3a, 3b) et le
premier point de fixation (3a) est en contact électrique avec le deuxième point de fixation (3b), de sorte que la première (1a) et la deuxième (1b) cartes de circuits imprimés sont en contact électrique l'une avec l'autre à l'aide de la piste conductrice (10) disposée dans le boîtier (2) et que la connexion électrique des au moins deux cartes de circuits imprimés (1a, 1b) est réalisée simultanément à la fixation
des cartes de circuits imprimés (1a, 1b) dans le boîtier (2).

4. Dispositif de cartes de circuits imprimés (13) selon la revendication 3,
les premier (3a) et deuxième (3b) points de fixation pouvant être reliés électriquement plusieurs fois,
le boîtier (2) comportant au moins deux pistes conductrices isolées électriquement l'une de l'autre (10, 11),
et dans lequel, à l'aide des pistes conductrices (10, 11) isolées électriquement les unes des autres, le premier (3a) et le deuxième (3b) points de fixation sont reliés électriquement entre eux à plusieurs reprises dans des zones (4a, 5a ; 4b, 5b) isolées électriquement les unes des autres.

5. Dispositif à circuit imprimé (13) selon au moins l'une des revendications 3 à 4,
dans lequel, lors de la mise en contact électrique, le circuit imprimé (1a ; 1b) et le point de fixation (3a ; 3b) sont mis en contact par l'intermédiaire d'une surface de contact (19),
et dans lequel, sur la base d'un dimensionnement du point de fixation (3a ; 3b) ainsi que sur la base configuration de la carte de circuit imprimé (1a ; 1b), les propriétés de contact de la surface de contact (19) sont réglables.

6. Dispositif de carte de circuit imprimé (13) selon au moins l'une des revendications 3 à 5,
au moins l'un des points de fixation (3a ; 3b) étant conçu comme une rainure élastiquement déformable
(14)
la carte de circuit imprimé (1a ; 1b) pouvant être insérée dans la rainure (14),
et la carte de circuit imprimé (1a ; 1b) étant fixée dans le boîtier (2) à l'aide de la liaison de la carte de circuit imprimé (1a ; 1b) avec la rainure élastiquement déformable.

7. Dispositif de carte de circuit imprimé (13) selon au moins l'une des revendications 3 à 6,
une douille élastiquement déformable (15) étant disposée sur la carte de circuit imprimé (1a ; 1b), au moins un point de fixation (3a ; 3b) étant conçu comme une contrepartie (16) adaptée à la douille élastiquement déformable (15),
la contrepartie adaptée (16) pouvant être insérée dans la douille élastiquement déformable (15) ,
et la carte de circuit imprimé (1a ; 1b) étant fixée dans le boîtier (2) par la liaison de la douille élastiquement déformable (15) avec la contre-pièce (16) de la douille élastiquement déformable (15).

8. Dispositif à carte de circuit imprimé (13) selon au moins l'une des revendications 3 à 7,
dans lequel une couche de recouvrement isolante recouvre au moins une piste conductrice (4 ; 4b) au moins par sections.

9. Dispositif à circuit imprimé (13) selon au moins l'une des revendications 3 à 8,
le boîtier (2) comportant plusieurs composants de boîtier (6, 7).

10. Dispositif à circuit imprimé (13) selon la revendication 9,
un premier composant de boîtier (6) étant en forme de coupelle, un
autre composant de boîtier (7) étant en forme de couvercle,
le composant de boîtier en forme de couvercle (7) étant conçu pour fermer le composant de boîtier en forme de godet (6) (6) en forme de coupelle,
et dans lequel la au moins une piste conductrice (10) est disposée dans le composant de boîtier en forme de couvercle (7).

11. Dispositif à circuit imprimé (13) selon la revendication 9 ou 10,
dans lequel au moins un composant de boîtier (6) est conçu pour diviser le boîtier (2) en au moins deux chambres de boîtier (17, 18) séparées l'une de l'autre dans l'espace,
et dans lequel la première carte de circuit imprimé (1a) est disposée dans la première chambre de boîtier (17) et la deuxième
carte de circuit imprimé (1b) est disposée dans la deuxième chambre de boîtier (18).

12. Dispositif de cartes de circuits imprimés (13) selon au moins l'une des revendications 3 à 11, la première (1a) et la deuxième (1b) cartes de circuits imprimés étant disposées essentiellement dans des plans parallèles l'un à l'autre,
les cartes de circuits imprimés (1a, 1b) étant reliées entre elles au moyen d'au moins deux pistes conductrices (10, 11)
sont en contact électrique l'un avec l'autre,
et les deux pistes conductrices (10, 11) étant disposées essentiellement dans des zones opposées (8, 9) du boîtier (2).

13. Dispositif à circuits imprimés (13) selon au moins l'une des revendications 3 à 12,
dans lequel au moins trois circuits imprimés (1a, 1b, 1c) sensiblement parallèles sont prévus, les trois circuits imprimés parallèles (1a, 1b, 1c) étant en contact électrique les uns avec les autres au moyen d'au moins deux pistes conductrices (10, 11),
les deux pistes conductrices (10, 11) étant disposées essentiellement sur des côtés opposés du boîtier (2).

14. Dispositif à circuits imprimés (13) selon au moins l'une des revendications 3 à 13, dans lequel au moins trois circuits imprimés (1a, 1b, 1c) sont prévus,
et dans lequel, à l'aide d'au moins trois pistes conductrices (10, **11,** 12) isolées les unes des autres respectivement
- la première carte de circuit imprimé (1a) est reliée à la deuxième carte de circuit imprimé (1b),
- la deuxième carte de circuit imprimé (1b) avec la troisième carte de circuit imprimé (1c) et
- la première carte de circuit imprimé (1a) avec la troisième
carte de circuit imprimé (1c).
